# EUROPEAN PATENT APPLICATION

(11) **EP 2 725 579 A1**
(43) Date of publication of application: **30.04.2014**
(21) Application number: 12290374.3
(22) Date of filing: 29.10.2012
(51) Int. Cl.: G11C 11/16

(54) **TA-MRAM cell with seed layer having improved data retention, reduced writing and reading fields**

(71) Applicant: Crocus Technology S.A., 38025 Grenoble Cedex (FR)
(72) Inventor: Bandiera, Sébastien, 38700 La Tronche (FR); Ducruet, Clarisse, 38000 Grenoble (FR); Prejbeanu, Ioan Lucian, 38170 Seyssinet Pariset (FR)
(74) Representative: P&TS SA (AG, Ltd.)

(57) **Abstract**

The present disclosure concerns a MRAM cell (1) comprising a magnetic tunnel junction (2) comprising: a sense layer (21) having a sense magnetization (210) that is freely switchable; a storage layer (23) having a storage magnetization (230); a tunnel barrier layer (22) comprised between the sense and the storage layers (21, 23); and an antiferromagnetic layer (24) pinning the storage layer (23) at a low temperature threshold and freeing it at a high temperature threshold; wherein the tunnel magnetic junction (2) further includes a seed layer (25) comprising a NiFe -based alloy and being arranged such that the antiferromagnetic layer (24) is comprised between the seed layer (25) and the storage layer (23). The present disclosure further concerns a magnetic memory device comprising a plurality of the MRAM cell (1) and a method for writing and a self-referenced method for reading the MRAM cell (1).

## Description

### Field

The present disclosure concerns a magnetic random access memory (MRAM) cell having enhanced exchange bias field between an antiferromagnetic layer and a storage layer of the MRAM cell. The present disclosure also concerns a method for writing and reading a thermally assisted MRAM cell.

### Description of related art

Spintronic devices such as MRAM cells and devices based on MRAM cells, spin transfer torque oscillators or magnetic logic units, usually comprise a magnetic tunnel junction including a reference or sense layer, a tunnel barrier layer and a storage layer exchange-coupled or not with an antiferromagnetic layer. The antiferromagnetic layer is arranged to pin a magnetization of the ferromagnetic layer at a low temperature threshold and frees it a high temperature threshold via a so-called exchange bias, appearing when the antiferromagnetic layer is in contact with the ferromagnetic layer. The exchange bias is thus of great importance in the functioning of spintronic devices.

The exchange bias phenomenon is characterized by a shifted magnetization hysteresis loop measured for pinned ferromagnetic layer, as a function of an applied magnetic field. In general, the exchange bias is impacted by the crystallographic properties induced by seed layers. Moreover, a large roughness of the seed layers on which the antiferromagnetic layer is grown can play a negative role both on magnetic switching properties of the ferromagnetic layer and on the reliability of the tunnel barrier.

### Summary

The present disclosure concerns a MRAM cell comprising a magnetic tunnel junction having a stack comprising; a sense layer having a sense magnetization; a storage layer having a storage magnetization; a tunnel barrier layer comprised between the sense and the storage layers; and an antiferromagnetic layer pinning the storage layer at a low temperature threshold and freeing it at a high temperature threshold; wherein the tunnel magnetic junction further includes a seed layer comprising a NiFe -based alloy and being arranged such that the antiferromagnetic layer is comprised between the seed layer and the storage layer.

The present disclosure further concerns a method for writing the MRAM cell comprising:
heating the magnetic tunnel junction at the high temperature threshold;
once the magnetic tunnel junction has reached the high temperature threshold, switching the storage magnetization in the written state; and
cooling the magnetic tunnel junction to the low temperature threshold such as to freeze the storage magnetizations in the written state.

The present also pertains to a method for reading the MRAM cell wherein the sense magnetization is freely switchable (i.e., the MRAM cell having a self-referenced configuration), the method comprising:
applying a first read magnetic field adapted for aligning the sense magnetization in a first direction;
determining a first resistance value of the magnetic tunnel junction;
applying a second read magnetic field adapted for aligning the sense magnetization in a second direction opposed to the first direction;
determining a second resistance value of the magnetic tunnel junction; and
comparing the first and second resistance values such as to determine a tunnel magnetoresistance or magnetoresistance, wherein the magnetoresistance corresponds to the ratio of the first second resistance on the second resistance.

The MRAM cell comprising the seed layer has a high exchange bias coupling field between the antiferromagnetic layer and the storage layer, the large exchange bias coupling field being favoured by the presence of NiFe-based seed layer. An enhanced exchange bias field is advantageous for improved data retention and prevents accidental switching of the cell in presence of large external parasitic fields. Advantageously, the NiFe seed layer can have a reduced roughness by incorporating nitrogen in the film during the growth of the seed layer.

Moreover, if the selected seed layers are magnetized, they can be advantageously used for reducing the reading and the writing fields. In particular, for the MRAM cell having the self-reference configuration, the seed layer can have a magnetization that can be advantageously used for the dipolar writing of the magnetization of the storage layer. The self-referenced MRAM cell can further be advantageously read by using a reduced magnetic field due to a stray field from the seed layer cancelling or reducing astray field coming from the storage layer.

### Brief Description of the Drawings

The invention will be better understood with the aid of the description of an embodiment given by way of example and illustrated by the figures, in which:
Fig. 1 illustrates a magnetic tunnel junction comprising a storage layer, a sense layer and a seed layer, according to an embodiment;
Fig. 2 represents a MRAM cell comprising the magnetic tunnel junction of Fig. 1, according to an embodiment;
Fig. 3 illustrates the orientations of the sense, storage and seed magnetizations during a write operation (a) and during a read operation (b);
Fig. 4 shows an hysteresis loop for the magnetic tunnel junction of Fig. 1 wherein the storage layer comprises a CoFe alloy, according to an embodiment;
Fig. 5 shows an hysteresis loop for the magnetic tunnel junction of Fig. 1 wherein the storage layer comprises a NiFe alloy, according to an embodiment;
Fig. 6 compares a hysteresis loop for the magnetic tunnel junction wherein the seed layer comprises a NiFe alloy to the magnetic tunnel junction wherein the seed layer comprises a NiFeN alloy.

### Detailed Description of possible embodiments

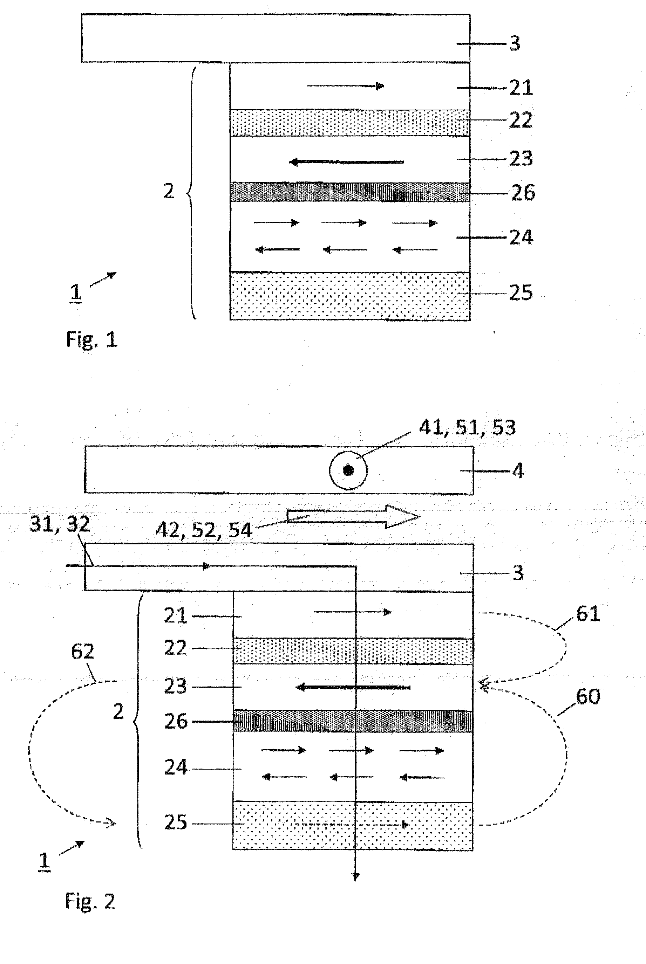

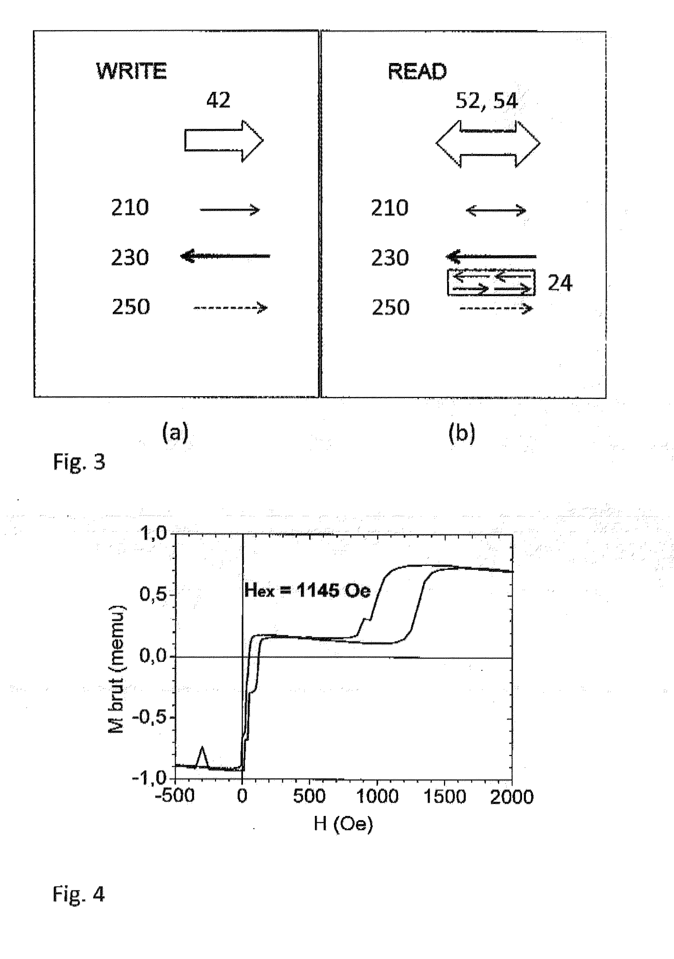

Figs. 1 and 3 illustrate a magnetic random access memory (MRAM) cell 1 comprising a magnetic tunnel junction 2, according to an embodiment. The magnetic tunnel junction 2 comprises a stack including a first magnetic layer 21 having a first magnetization 210, a second magnetic layer 23 having a second magnetization 230 and a tunnel barrier layer 22 comprised between the first and second magnetic layer (21, 23). The first magnetization 210 can be is freely switchable such that the first magnetic layer 21 corresponds to a sense layer. Alternatively, the first magnetization 210 can be fixed in the whole range of temperature and magnetic field used during writing of the MRAM cell 1. In that latter case, the first magnetic layer 21 corresponds to a reference layer. The second magnetic layer 23, or storage layer, is exchange-coupled with an antiferromagnetic layer 24 such that the second magnetization 230 is pinned at a low temperature threshold and freely orientable at a high temperature threshold. In this configuration, the MRAM cell 1 can be used as a self-referenced MRAM cell. The storage layer 23 can comprise one or more of a CoFe, CoFeB or NiFe layer, or more generally a Co, Ni or Fe -based alloy. The antiferromagnetic layer 24 can comprise a manganese-based alloy, such as IrMn, PtMn or FeMn, a multilayer structure comprising a combination of manganese-based alloys, or any other suitable materials. The stack can further include a seed layer 25 comprising a NiFe -based alloy and being arranged such that the antiferromagnetic layer 24 is comprised between the seed layer 25 and the storage layer 23. The thicknesses of the seed layer 25 can be between 1 nm and 10 nm.

In an embodiment, the seed layer 25 comprises a NixFey alloy. Preferably, x is equal to 81 and y is equal to 19. The thicknesses of the seed layer 25 can be between 1 nm and 10 nm.

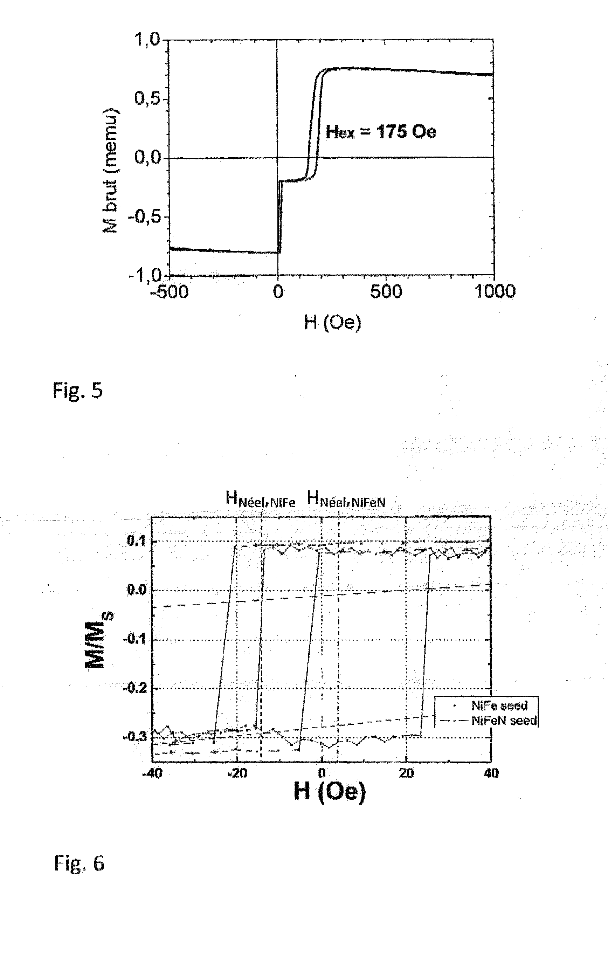

In another embodiment, the NiFe -based alloy of the seed layer 25 further comprises nitrogen. Nitrogen can be incorporated in the NiFe film structure by introducing a nitrogen flow in the argon plasma during the sputtering process of the seed layer 25 Adding nitrogen in the NiFe seed layer 25 results in a reduced roughness of the seed layer 25, for example below 0.3 nm RMS. Other advantages of adding nitrogen to the seed layer 25 include reducing the saturation magnetization of the seed layer 25 , for example from 800 emu/cm³ down to 0 emu/cm³ for nonmagnetic layer, and increasing the electrical resistivity of the seed layer 25, for example from 23.5 µohm.cm up to about 0.5 mohm.cm. The increased electrical resistivity of the seed layer 25 improves heating of the magnetic tunnel junction 2 during a write operation (see below). The increased electrical resistivity has a positive impact on the local heating of the antiferromagnetic layer 24. The seed layer 25 comprising the NiFeN composition has reduced Néel coupling compared to the seed layer 25 comprising NiFe. The reduction in Néel coupling results from the reduced roughness of the NiFeN seed layer 25. Fig. 6 compares a hysteresis loop for the magnetic tunnel junction 2 wherein the seed layer 25 comprises a NiFe alloy exhibiting a Néel coupling H_{Néel},_{NiFe} of about -15 Oe with the magnetic tunnel junction 2 wherein the seed layer 25 comprises a NiFeN alloy exhibiting a Néel coupling H_{Néel},_{NiFeN} of about 5 Oe.

Fig. 4 reports a hysteresis loop measured experimentally for the magnetic tunnel junction 2 wherein the seed layer comprises a NiFe alloy, the antiferromagnetic layer 24 comprises an IrMn alloy and the storage layer 23 comprises a CoFe alloy. Fig. 5 report another hysteresis loop measured experimentally for the same magnetic tunnel junction 2 as the one of Fig. 4 but wherein the storage layer 23 comprises a NiFe alloy, Comparison of Figs. 4 and 5 shows that the exchange bias field between antiferromagnetic layer 24 and the storage layer 23 measured in Fig. 4 (1145 Oe) is almost one order of magnitude larger than the exchange bias field measured in Fig. 5 (175 Oe). In any case, the most important parameter describing the exchange bias interaction is the exchange coupling constant, Jₑₓ, which is summarized in Table 1 for different combinations of seed layer 25 and ferromagnetic storage layer 23 in the presence of a IrMn antiferromagnetic layer 24.

In yet another embodiment, the storage layer 23 comprises a storage interface layer 26 including a CoFe -based alloy. The thickness of the storage interface layer 26 is between 0.1 nm and 10 nm, but preferentially between 0.5 nm and 2 nm. The storage interface layer 26 including a CoFe -based alloy allows for increasing the exchange bias field between antiferromagnetic layer 24 and the storage layer 23 even in the case the storage layer comprise the NiFe alloy. The CoFe interface storage layer 26, located at the interface between the storage layer 23 and the antiferromagnetic layer 24, allows for increasing the exchange magnetic bias field Hₑₓ.

Table 1 summarises values corresponding to the exchange bias interaction Jₑₓ for different configurations the stack. In particular, examples 1, 2 and 3 compare configurations of the stack comprising an IrMn antiferromagnetic layer 24 and a NiFe storage layer 23 (example 3), or CoFe storage layer 23 or storage interface layer 26 (examples 1 and 2) In contrast to examples 2 and 3, the stack configuration of example 1 does not include the seed layer 25. Examples 4 to 6 compare configurations of the stack comprising a PtMn antiferromagnetic layer 24, the NiFe seed layer 25 and a NiFe storage layer 23 (examples 4 and 6) or CoFe storage layer 23 or storage interface layer 26 (example 5). Table 1 also reports the value of the saturation magnetization of the storage layer M₅ in emu/cm³, and the thickness in nm of the storage layer 23 for each configuration of the magnetic tunnel junction 2. The highest exchange bias interaction Jₑₓ (highest exchange coupling between the antiferromagnetic layer 24 and the storage layer 23) is obtained for the NiFe/IrMn/CoFe stack configuration.

A magnetic memory device (not represented) can comprise a plurality of the MRAM cell 1 arranged in rows and columns. The magnetic memory device can further comprise one or a plurality of the current line 3 that connect the MRAM cells 1 along a row (or column), and possibly one or a plurality of the field line 4 coupled to the MRAM cells 1 along a column (or row).

**Table 1**

| | Configuration of the stack | Saturation magnetization of storage layer, M₅ (emu/cm³) | Thickness of storage layer (nm) | Exchange coupling constant, Jex (erg/cm²) |
|---|---|---|---|---|
| 1 | IrMn-/CoFe | 1550 | 5 | 0.23 |
| 2 | NiFe seed ArMn/CoFe | 1550 | 1 | 0.589 |
| 3 | NiFe seed /irMn/NiFe | 800 | 2 | 0.032 |
| 4 | NiFe seed /PtMn/NiFe | 800 | 5 | 0.196 |
| 5 | NiFe seed /PtMn/CoFeB | 1150 | 5 | 0.43 |
| 6 | NiFe seed /PtMn/NiFe | 800 | 3 | 0.45 |

According to an embodiment, a thermally assisted switching (TAS) write operation comprises:
heating the magnetic tunnel junction 2 to a high temperature threshold;
once the magnetic tunnel junction 2 has reached the high temperature threshold, switching the storage magnetizations 230 in the written state (write data); and
cooling the magnetic tunnel junction 2 to the low temperature threshold such as to freeze the storage magnetizations 230 in the written state.

Heating the magnetic tunnel junction 2 can comprise passing a heating current 31 in the magnetic tunnel junction 2 via a current line 3 electrically connected to an end of the magnetic tunnel junction 2 (See Fig. 2).

Switching the storage magnetization 230 is performed by applying the external write magnetic field 42. The write magnetic field 42 can be applied by passing a write current 41 in a field line 4 in communication with the magnetic tunnel junction 2. In the example of Fig. 2, the field line is shown on top of the current line 3. Alternatively, the write current 41 can be passed in the current line 3 such that the field line 4 can be avoided.

In an embodiment, the magnetic field 42 is applied with a magnitude such as to saturate a seed magnetization 250 of the seed layer 25 in a direction according to the direction of the write magnetic field 42 (shown oriented toward the right hand side of the page in Fig. 2). The saturated seed magnetization 250 induces in turn a local seed magnetic stray field 60 coupling the storage magnetization 230 in a closed magnetic flux configuration (see Fig. 2). During the write operation, the magnetic field 42 also saturates the sense magnetization 210 of the sense layer 21 such as to induce a local sense magnetic stray field 61 also coupling the sense magnetization 210 with the storage magnetization 230 (see Fig. 2). Since both seed and sense magnetic stray fields 60, 61 are oriented in the same direction, the storage magnetization 230 is oriented in accordance with a net magnetic stray field that is the sum of the seed magnetic stray field 60 and sense magnetic stray field 61. Thus, the seed magnetic stray field 60 increases the net magnetic stray field used for switching of the storage magnetization 230 in comparison to when only the sense magnetic stray field 61 is used. Figs. 2 and 3a illustrate the parallel orientations of the sense and seed magnetizations 210, 250 during the write operation.

The distance between the storage layer 23 and the seed layer 25 being small, typically in the nanometer range, the storage layer 23 is thus more effectively switched with the saturated seed magnetization 250 than when switched directly with the write magnetic field 42 generated by the field line 4.

According to an embodiment, a self-referenced read operation of the MRAM cell 1 comprises:
applying a first read magnetic field 52 adapted for aligning the sense magnetization 210 in a first direction, in accordance with the first orientation of the first read magnetic field 52;
determining a first resistance value R₁ of the magnetic tunnel junction 2;
applying a second read magnetic field 54 adapted for aligning the sense magnetization 210 in a second direction opposed to the first direction, in accordance with the second orientation of the second read magnetic field 54;
determining a second resistance value R₂ of the magnetic tunnel junction 2; and
comparing the first and second resistance values R₁, R₂ such as to determine a tunnel magnetoresistance or magnetoresistance ∧R = R₁/R₂.

Figs. 2 and 3b illustrate the relative orientations of the sense and seed magnetizations 210, 250 during the read operation. During the read operation, i.e., upon applying the first and second read magnetic field 52, 54, the storage magnetization 230 is oriented antiparallel to the seed magnetization 250 such that the seed magnetic stray field 60 is opposed to a storage magnetic stray field 62 generated by the storage magnetization 230. In this arrangement, the net magnetic stray field coupling the sense layer 21, corresponding to the sum of the seed magnetic stray field 60 and the storage magnetic stray field 62, is substantially null. The first and second read magnetic fields 52, 54 required for orienting the sense magnetization 210 can thus be reduced.

The first read magnetic field 52 can be applied by passing a first read field current 51 having a first polarity in the field line 4 (or in the current line 3). The first direction of the sense magnetization 210 is then compared with the storage magnetization 230 by passing a sense current 32 in the magnetic tunnel junction 2 via the current line 3. The voltage measured across the magnetic tunnel junction 2 yields a corresponding first resistance value R₁ of the magnetic tunnel junction 2. In the case the sense magnetization 210 is aligned substantially parallel to the storage magnetization 230 the first resistance value R₁ is small (R₁ = Rₘᵢₙ). On the other hand, when the sense magnetization 210 is aligned substantially antiparallel to the storage magnetization 230 the measured first resistance value is high (R₁ = Rmax).

The second read magnetic field 54 can be applied by passing a second read field current 53 having a second polarity in the field line 4 (or in the current line 3). The second direction of the sense magnetization 210 is then compared with the storage magnetization 230 by passing the sense current 32 in the magnetic tunnel junction 2. Measuring a voltage across the magnetic tunnel junction 2 when the sense current 32 is passed through the magnetic tunnel junction 2 yields a corresponding second resistance value R₂ of the magnetic tunnel junction 2.

Alternatively, the write operation comprises only the step of applying the first read magnetic field 52 and of determining a first resistance value R₁. The first resistance value R₁ can be compared to a reference resistance typically halfway between Rₘᵢₙ and Rₘₐₓ.

**Reference Numbers and symbols**

| | |
|---|---|
| 1 | MRAM cell |
| 2 | magnetic tunnel junction |
| 21 | first magnetic layer, sense layer |
| 210 | sense magnetization |
| 22 | tunnel barrier layer |
| 23 | second magnetic layer, storage layer |
| 230 | storage magnetization |
| 24 | antiferromagnetic layer |
| 25 | seed layer |
| 250 | seed magnetization |
| 26 | storage interface layer |
| 31 | heating current |
| 32 | sense current |
| 51 | first read field current |
| 52 | first read magnetic field |
| 53 | second read field current |
| 54 | second read magnetic field |
| 60 | seed magnetic stray field |
| 61 | sense magnetic stray field |
| 62 | storage magnetic stray field |
| | |
| Jₑₓ | exchange bias interaction |
| Hₑₓ | exchange magnetic bias field |
| H_{Néel},_{NiFe} | Néel coupling |
| H_{Néel},_{NiFeN} | Néel coupling |
| M₅ | magnetization |
| ∧R | tunnel magnetoresistance |
| R₁ | first resistance value |
| R₂ | second resistance value |

## Claims

1. MRAM cell (1) comprising a magnetic tunnel junction (2) comprising a stack including:
a sense layer (21) having a sense magnetization (210) that is freely alignable;
a storage layer (23) having a storage magnetization (230);
a tunnel barrier layer (22) comprised between the sense and the storage layers (21, 23); and
an antiferromagnetic layer (24) pinning the storage layer (23) at a low temperature threshold and freeing it at a high temperature threshold; **characterized in that**
the tunnel magnetic junction (2) further includes a seed layer (25) comprising a NiFe -based alloy and being arranged such that the antiferromagnetic layer (24) is comprised between the seed layer (25) and the storage layer (23).

2. The MRAM cell (1) according to claim 1, wherein
the seed layer (25) comprises a NixFey alloy.

3. The MRAM cell (1) according to claim 2, wherein
the seed layer (25) comprises a Ni81Fe19 alloy.

4. The MRAM cell (1) according to any of the claims 1 to 3,
wherein
the thicknesses of the seed layer (25) varies between 1 nm and 10 nm.

5. The MRAM cell (1) according to any of the claims 1 to 4,
wherein
the seed layer (25) further comprises nitrogen.

6. The MRAM cell (1) according to any of the claims 1 to 5,
wherein
the storage layer (23) comprises a Co, Ni or Fe -based alloy or one or more of a CoFe, CoFeB or NiFe layer.

7. The MRAM cell (1) according to any of the claims 1 to 6,
wherein
the magnetic tunnel junction (2) further comprises a storage interface layer (26) comprising a CoFe alloy at the interface between the storage layer (23) and the antiferromagnetic layer (24).

8. The MRAM cell (1) according to claim 7, wherein
the storage interface layer (26) has a thickness between 0.1 nm and 10 nm, and preferably between 0.5 nm and 2 nm.

9. A magnetic memory device comprising a plurality of the MRAM cell (1) **characterized by** any one of claims 1 to 8.

10. A method for writing the MRAM cell (1) **characterized by** any one of claims 1 to 8, comprising:
heating the magnetic tunnel junction (2) at the high temperature threshold;
once the magnetic tunnel junction (2) has reached the high temperature threshold, switching the storage magnetization (230) in the written state; and
cooling the magnetic tunnel junction (2) to the low temperature threshold such as to freeze the storage magnetizations (230) in the written state.

11. The method according to claim 10, wherein
switching the storage magnetization (230) comprises applying a write magnetic field (42) such as to saturate a seed magnetization (250) of the seed layer (25);
a magnetic stray field (60) induced by the saturated seed magnetization (250) switching the storage magnetization (230).

12. The method according to claim 11, wherein
the magnetic field (42) further saturates the sense magnetization (210) such as to induce a sense magnetic stray field (61) oriented in the same direction as the seed magnetic stray field (60) such that the storage magnetization (230) is oriented in accordance with a net magnetic stray field being the sum of the seed magnetic stray field (60) and sense magnetic stray field (61).

13. A method for reading the MRAM cell (1) **characterized by** any one of claims 1 to 8, wherein the sense magnetization (210) is freely switchable, the method comprising:
applying a first read magnetic field (52) adapted for aligning the sense magnetization (210) in a first direction;
determining a first resistance value (R₁) of the magnetic tunnel junction (2);
applying a second read magnetic field (54) adapted for aligning the sense magnetization (210) in a second direction opposed to the first direction;
determining a second resistance value (R₂) of the magnetic tunnel junction (2); and
comparing the first and second resistance values (R₁, R₂) such as to determine a tunnel magnetoresistance or magnetoresistance (ΔR= R₁/R₂).

14. The method according to claim 13, wherein
applying the first and second read magnetic field (52, 54) further comprises orienting the seed magnetization (250) antiparallel to the storage magnetization (230), such that the net magnetic stray field coupling the sense layer (21), corresponding to the sum of the seed magnetic stray field (60) and a storage magnetic stray field (62) generated by the storage magnetization (230), is substantially null.
